(19) Europäisches Patentamt / European Patent Office / Office européen des brevets

(11) **EP 3 252 901 B1**

(12) **EUROPÄISCHE PATENTSCHRIFT**

(45) Veröffentlichungstag und Bekanntmachung des Hinweises auf die Patenterteilung:
**24.08.2022 Patentblatt 2022/34**

(21) Anmeldenummer: **17170409.1**

(22) Anmeldetag: **10.05.2017**

(51) Internationale Patentklassifikation (IPC):
**H02H 1/00** *(2006.01)* **G01R 31/12** *(2020.01)*

(52) Gemeinsame Patentklassifikation (CPC):
**G01R 31/52; H02H 1/0015**

(54) **STÖRLICHTBOGENERKENNUNGSEINHEIT**

ARC FAULT DETECTION UNIT

UNITÉ DE DÉTECTION D'ARC ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.05.2016 DE 102016209444**

(43) Veröffentlichungstag der Anmeldung:
**06.12.2017 Patentblatt 2017/49**

(73) Patentinhaber: **Siemens Aktiengesellschaft 80333 München (DE)**

(72) Erfinder:
• **Wenzlaff, Karsten**
  **01097 Dresden (DE)**
• **Meyer, Jörg**
  **01157 Dresden (DE)**
• **Schegner, Peter**
  **01259 Dresden (DE)**

(56) Entgegenhaltungen:
EP-A1- 2 916 455    EP-A2- 2 424 059
DE-A1-102004 056 436    US-B2- 7 627 400

**Beschreibung**

Die Erfindung betrifft eine Störlichtbogenerkennungseinheit, einen Leistungsschalter, einen Kurzschließer und ein Verfahren zur Störlichtbogenerkennung.

In Niederspannungsstromkreisen bzw. Niederspannungsanlagen respektive Niederspannungsnetzen, d.h. Stromkreise für Spannungen bis 1000 Volt Wechselspannung oder 1500 Volt Gleichspannung, sind Kurzschlüsse meist mit auftretenden Störlichtbögen, wie parallele oder serielle Störlichtbögen, verbunden. Besonders in leistungsstarken Verteil- und Schaltanlagen können diese bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personenschäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen (z.B. Sicherungen und Leistungsschalter) können unter den geforderten zeitlichen Anforderungen keinen zuverlässigen Schutz bieten.

Mit Leistungsschalter sind hier insbesondere Schalter für Niederspannung gemeint. Leistungsschalter werden, insbesondere in Niederspannungsanlagen, üblicherweise für Ströme von 63 bis 6300 Ampere eingesetzt. Spezieller werden geschlossene Leistungsschalter, wie Moulded Case Circuit Breaker, für Ströme von 63 bis 1600 Ampere, insbesondere von 125 bis 630 oder 1200 Ampere eingesetzt. Offene Leistungsschalter bzw. Luftleistungsschalter, wie Air Circuit Breaker, werden insbesondere für Ströme von 630 bis 6300 Ampere, spezieller von 1200 bis 6300 Ampere eingesetzt.

Leistungsschalter im Sinne der Erfindung können insbesondere eine elektronischen Auslöseeinheit, auch als Electronic Trip Unit, kurz ETU, bezeichnet, aufweisen.

Leistungsschalter überwachen den durch sie hindurchfließenden Strom und unterbrechen den elektrischen Strom bzw. Energiefluss zu einer Energiesenke bzw. einem Verbraucher, was als Auslösung bezeichnet wird, wenn Stromgrenzwerte oder Strom-Zeitspannengrenzwerte, d.h. wenn ein Stromwert für eine gewisse Zeitspanne vorliegt, überschritten werden. Die Ermittlung von Auslösebedingungen und das Auslösen eines Leistungsschalters können mittels einer elektronischen Auslöseeinheit erfolgen.

Kurzschließer sind spezielle Einrichtungen zum Kurzschließen von Leitungen bzw. Stromschienen, um definierte Kurzschlüsse zum Schutz von Stromkreisen bzw. Anlagen herzustellen.

Konventionelle Störlichtbogendetektionssysteme werten die durch den Lichtbogen erzeugte Lichtemission aus und detektieren hiermit den Störlichtbogen.

Dies hat den Nachteil, dass parallel zu den elektrischen Leitungen bzw. Stromschienen Lichtwellenleiter bzw. optische Detektionssysteme verlegt werden müssen, um eventuell auftretende Störlichtbögen zu erkennen.

In der europäischen Patentanmeldung EP 2 916 455 A1 wird eine Einrichtung zum Detektieren eines seriellen Lichtbogens in einer elektrischen Anlage offenbart. Diese Anmeldung betrifft eine Einrichtung zum Detektieren eines seriellen Lichtbogens in einer elektrischen Anlage, die eine elektrische Gleichspannungsquelle sowie einen an die Gleichspannungsquelle angeschlossenen Wechselrichter umfasst, wobei die Einrichtung eine Überwachungseinheit, die eingerichtet ist, in der elektrischen Anlage eine elektrische Spannung auf Spannungsänderungen und einen elektrischen Strom auf Stromänderungen zu überwachen, sowie eine Auswerteeinheit aufweist, die einge richtet ist, die ermittelten Spannungs- und Stromänderungen zum Detektieren des seriellen Lichtbogens auszuwerten und ein Signal entsprechend eines Ergebnisses des Auswertens zu erzeugen. Erfindungsgemäß umfasst die Einrichtung eine Ermittlungseinheit zum Ermitteln, ob eine spontane Änderung eines aktuellen bestimmungsgemäßen Betriebszustands vorliegt, bei der sowohl die elektrische Spannung als auch der elektrische Strom reduziert sind, eine Vergleichseinheit zum Vergleichen eines Betrags der Spannungsänderungen und eines Betrags der zu den Spannungsänderungen zeitlich zugeordneten Stromänderungen mit jeweiligen Vergleichswerten sowie Ermitteln von Lichtbogenindikatorwerten basierend auf den Spannungsänderungen und den Stromänderungen bei Überschreiten von wenigstens einem der Vergleichswerte durch die jeweiligen Beträge, eine Prüfeinheit zum Prüfen der Lichtbogenindikatorwerte auf Periodizitäten, und Ausgabeeinheit zum Ausgeben des Signals bei negativem Prüfergebnis.

In der europäischen Patentanmeldung EP 2 424 059 A2 wird ein Verfahren, System und Gerät zur Erkennung von Lichtbogenereignissen unter Verwendung von Strom und Spannung offenbart.

In der amerikanischen Patentschrift US 7,627,400 B2 wird ein Verfahren und eine Einrichtung zur Detektion elektrischer Lichtbogenphänomene an einem elektrischen Kabel offenbart.

In der deutschen Offenlegungsschrift DE 10 2004 056 436 A1 wird ein Verfahren und Vorrichtung zur Erkennung von Fehlerstrom-Lichtbögen in elektrischen Stromkreisen für Verbraucher mit relativ konstanter Leistungsaufnahme, insbesondere in Flugzeugbordnetzen, offenbart.

Aufgabe der vorliegenden Erfindung ist es, eine Möglichkeit zur Störlichtbogenerkennung aufzuzeigen.

Diese Aufgabe wird durch eine Störlichtbogenerkennungseinheit mit den Merkmalen des Patentanspruchs 1, einen Leistungsschalter gemäß Patentanspruch 22, einen Kurzschließer gemäß Patentanspruch 23 und ein Verfahren mit den Merkmalen des Patentspruchs 24 gelöst.

Erfindungsgemäß ist vorgesehen, dass eine Störlichtbogenerkennungseinheit für einen elektrischen Niederspannungsstromkreis mindestens einen dem Stromkreis zugeordneten Spannungssensor, zur periodischen Ermittlung von elektrischen Spannungswerten des Stromkreises, mindestens einen dem Stromkreis zugeordneten Stromsensor, zur periodischen Ermittlung von elektrischen Stromgrößen des Stromkreises, aufweist. Diese sind mit einer Auswerteeinheit verbunden. Die Sensoren können dabei extern angeordnet sein und müssen nicht im Gehäuse der Störlichtbogenerkennungseinheit angeordnet sein.

Die Erkennungseinheit ist derart ausgestaltet, dass fortlaufend Wertepaare eines Spannungswertes und einer Stromgröße zu einem Zeitpunkt ermittelt werden, beispielsweise durch eine Abtastung der entsprechenden Werte, so dass jeweils ein erstes Wertepaar eines Spannungswertes (u1) und einer Stromgröße zu einem ersten Zeitpunkt und ein zweites Wertepaar eines Spannungswertes (u2) und einer Stromgröße zu einem zweiten Zeitpunkt vorliegen.

Aus den zwei Wertepaaren wird eine Lichtbogenspannung (Ulb) berechnet, die mit einem Schwellwert (SW) verglichen wird. Bei dessen betragsmäßiger Überschreitung wird ein Störlichtbogenerkennungssignal abgegeben.

Mit betragsmäßiger Überschreitung ist eine Überschreitung gemeint, bei der hinsichtlich eines positiven ersten Schwellwertes eine Überschreitung oder/und eines negativen zweiten Schwellwertes eine Unterschreitung erfolgen könnte, analog zu einem betragsmäßigen Vergleich der Lichtbogenspannung mit einem (positiven) Schwellwert.

Dies hat den besonderen Vorteil, dass eine einfache und sichere Möglichkeit zur Störlichtbogenerkennung gegeben ist.

Vorteilhafte Ausgestaltungen der Erfindung sind in den Unteransprüchen angegeben.

In einer vorteilhaften Ausgestaltung der Erfindung liegt ein drittes Wertepaar eines Spannungswertes (u3) und einer Stromgröße zu einem dritten Zeitpunkt vor.

Aus den drei Wertepaaren wird eine Lichtbogenspannung (Ulb) berechnet, die mit einem Schwellwert (SW) verglichen wird.

Bei dessen betragsmäßiger Überschreitung wird ein Störlichtbogenerkennungssignal abgegeben.

Dies hat den besonderen Vorteil, dass einen genauere und noch sichere Möglichkeit zur Störlichtbogenerkennung gegeben ist.

In einer vorteilhaften Ausgestaltung der Erfindung ist die elektrische Stromgröße entweder ein elektrischer Stromwert ($i_m$) oder ein Wert für die Änderung des elektrischen Stromes nach der Zeit ($i'_m$). Dies hat den besonderen Vorteil, dass nur eine Stromgröße, entweder Stromwert oder Änderung des elektrischen Stromes nach der Zeit, respektive die Ableitung des Stromes nach der Zeit, ermittelt werden braucht. Beispielsweise kann vorteilhaft zur Ermittlung der Stromgröße eine Rogowskispule verwendet werden, womit die Änderung des Stromes nach der Zeit erfasst wird.

In einer vorteilhaften Ausgestaltung der Erfindung wird im Falle der Ermittlung des elektrischen Stromwertes ($i_m$) daraus ein Wert für die Änderung des elektrischen Stromes nach der Zeit ($i'_m$), respektive die erste Ableitung des Stromwertes nach der Zeit, ermittelt oder im Falle der Ermittlung des Wertes für die Änderung des elektrischen Stromes nach der Zeit ($i'_m$) daraus der elektrische Stromwert ($i_m$) ermittelt. Ein Wertepaar weist damit vorteilhafterweise einen Spannungswert ($u_m$), einen Stromwert ($i_m$) und einen Wert für die Änderung des Stromes nach der Zeit ($i'_m$) auf, womit sich die Lichtbogenspannung (Ulb) berechnen lässt.

In einer vorteilhaften Ausgestaltung der Erfindung ist die Auswerteeinheit derart ausgestaltet, dass die Berechnung der Lichtbogenspannung (Ulb) mit Hilfe einer Differentialgleichung oder deren Lösung durchgeführt wird.

Dies hat den besonderen Vorteil, dass eine umfassende Berechnungsmöglichkeit unter Berücksichtigung vieler Parameter eines realen Stromkreises zur Verfügung steht.

In einer vorteilhaften Ausgestaltung der Erfindung ist die Auswerteeinheit derart ausgestaltet, dass für die Berechnung der Lichtbogenspannung (Ulb) mindestens einer der folgenden Terme gebildet wird:

ein erstes Produkt (P1), gebildet aus dem dritten Spannungswert (u3) und dem ersten Stromwert (i1),

ein zweites Produkt (P2), gebildet aus dem ersten Spannungswert (u1) und dem dritten Stromwert (i3),

ein drittes Produkt (P3), gebildet aus der ersten Ableitung des zweiten Stromwertes nach der Zeit (i'2) und dem ersten Stromwert (i1),

ein viertes Produkt (P4), gebildet aus der ersten Ableitung des ersten Stromwertes nach der Zeit (i'1) und dem zweiten Stromwert (i2),

ein fünftes Produkt (P5), gebildet aus dem zweiten Spannungswert (u2) und dem ersten Stromwert (i1),

ein sechstes Produkt (P6), gebildet aus dem ersten Spannungswert (u1) und dem zweiten Stromwert (i2),

ein siebtes Produkt (P7), gebildet aus der ersten Ableitung des dritten Stromwertes nach der Zeit (i'3) und dem ersten Stromwert (i1),

ein achtes Produkt (P8), gebildet aus der ersten Ableitung des ersten Stromwertes nach der Zeit (i'1) und dem dritten Stromwert (i3),

eine erste Differenz (D1), dessen Minuend aus dem Produkt des Vorzeichens des ersten Stromwertes (sgn(i1)) und dem zweiten Stromwert (i2) und dessen Subtrahend aus dem Produkt des Vorzeichens des zweiten Stromwertes (sgn(i2)) und dem ersten Stromwert (i1) gebildet wird,

eine zweite Differenz (D2), dessen Minuend aus dem Produkt des Vorzeichens des ersten Stromwertes (sgn(i1)) und dem dritten Stromwert (i3) und dessen Subtrahend aus dem Produkt des Vorzeichens des dritten Stromwertes (sgn(i3)) und dem ersten Stromwert (i1) gebildet wird,

eine dritte Differenz (D3), dessen Minuend das erste Produkt (P1) und dessen Subtrahend das zweite Produkt (P2) ist,

eine vierte Differenz (D4), dessen Minuend das dritte Produkt (P3) und dessen Subtrahend das vierte Produkt (P4) ist,

eine fünfte Differenz (D5), dessen Minuend das fünfte Produkt (P5) und dessen Subtrahend das sechste Produkt (P6) ist,

eine sechste Differenz (D6), dessen Minuend das siebte Produkt (P7) und dessen Subtrahend das achte Produkt (P8) ist, ein neuntes Produkt (P9), gebildet aus der dritten Differenz (D3) und der vierten Differenz (D4),

ein zehntes Produkt (P10), gebildet aus der fünften Differenz (D5) und der sechsten Differenz (D6),

ein elftes Produkt (P11), gebildet aus der ersten Differenz (D1) und der sechsten Differenz (D6),

ein zwölftes Produkt (P12), gebildet aus der zweiten Differenz (D2) und der vierten Differenz (D4),

eine siebte Differenz (D7), dessen Minuend das neunte Produkt (P9) und dessen Subtrahend das zehnte Produkt (P10) ist,

eine achte Differenz (D8), dessen Minuend das elfte Produkt (P11) und dessen Subtrahend das zwölfte Produkt (P12) ist. Dies hat den besonderen Vorteil, dass mit mindestens einem dieser Terme eine Ermittlung der Störlichtbogenspannung ermöglicht wird.

In einer vorteilhaften Ausgestaltung der Erfindung ist die Auswerteeinheit derart ausgestaltet, dass die Lichtbogenspannung (Ulb) ein Quotient ist, dessen Dividend die siebte Differenz (D7) aufweist und dessen Divisor die achte Differenz (D8) aufweist.

Dies hat den besonderen Vorteil, dass eine genaue Ermittlung einer Störlichtbogenspannung ermöglicht wird.

In einer vorteilhaften Ausgestaltung der Erfindung liegt der erste Zeitpunkt zeitlich vor dem zweiten Zeitpunkt. Alternativ liegt der zweite Zeitpunkt zeitlich vor dem dritten Zeitpunkt. Alternativ liegt der erste Zeitpunkt zeitlich vor dem zweiten Zeitpunkt liegt und dieser zeitlich vor dem dritten Zeitpunkt.

Dies hat den besonderen Vorteil, dass eine besonders genaue Ermittlung einer Störlichtbogenspannung ermöglicht wird.

Erfindungsgemäß ist ferner ein Leistungsschalter für einen elektrischen Niederspannungsstromkreis vorgesehen. Dieser weist eine erfindungsgemäße Störlichtbogenerkennungseinheit auf. Diese ist mit dem Leistungsschalter verbunden, wobei diese derart ausgestaltet sind, dass bei Abgabe eines Störlichtbogenerkennungssignals der Leistungsschalter auslöst, d.h. den elektrischen Stromkreis unterbricht. Somit kann eine Löschung des Störlichtbogens erreicht werden. Weist der Leistungsschalter eine elektronische Auslöseeinheit auf, kann eine sehr schnelle Auslösung des Leistungsschalters bei vorliegen eines Störlichtbogenerkennungssignals erreicht werden. Dies hat den besonderen Vorteil, dass ein Leistungsschalter um eine weitere, vorteilhafte Funktionalität zum Schutz elektrischer Anlagen erweitert wird. Die Erkennung und Abschaltung von Störlichtbögen erfolgt dabei vorteilhaft in einem Gerät. Gegebenenfalls lassen sich vorhandene Baugruppen, wie Spannungs- oder/und Stromsensoren, Netzteil, Mikroprozessoren für die Auswerteeinheit, etc. mitverwenden und so Synergien erzielen.

Erfindungsgemäß ist ferner ein Kurzschließer, aufweisend eine Störlichtbogenerkennungseinheit die mit dem Kurzschließer verbunden ist, vorgesehen. Diese sind derart ausgestaltet, dass bei Abgabe eines Störlichtbogenerkennungssignals der Kurzschließer den elektrischen Stromkreis kurzschließt, um ein Löschen des Störlichtbogens zu bewirken.

Dies hat den besonderen Vorteil, dass eine einfache, schnelle und wirksame Möglichkeit zum Löschen von Störlichtbögen zur Verfügung steht.

Erfindungsgemäß ist des Weiteren ein Verfahren zur Störlichtbogenerkennung für einen elektrischen Stromkreis, insbesondere Niederspannungsstromkreis, vorgesehen. Hierbei werden periodisch elektrische Spannungswerte und Stromwerte des Stromkreises ermittelt, so dass jeweils

ein erstes Wertepaar eines Spannungs- (u1) und eines Stromwertes (i1) zu einem ersten Zeitpunkt und

ein zweites Wertepaar eines Spannungs- (u2) und eines Stromwertes (i2) zu einem zweiten Zeitpunkt vorliegen.

Aus den zwei Wertepaaren wird eine Lichtbogenspannung (Ulb) berechnet, die mit einem Schwellwert (SW) verglichen wird. Bei dessen Überschreitung wird ein Störlichtbogenerkennungssignal abgegeben.

Dies hat den Vorteil, dass eine einfache Möglichkeit zur Erkennung eines Störlichtbogen auf Basis zweier Spannungs- und Stromwertepaare ermöglicht wird.

Alle Ausgestaltungen und Merkmale, sowohl einzeln auch als im gemeinsamen zusammenwirken, der Erfindung bewirken eine Verbesserung der Erkennung von Störlichtbögen bzw. deren Löschung.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Hierbei zeigt:

Figur 1 ein Diagramm des zeitlichen Spannungs- und Stromverlaufes nach Lichtbogenzündung

Figur 2 ein Ersatzschaltbild eines elektrischen Stromkreises

Figur 3 ein Ablaufdiagramm zur Störlichtbogenerkennung

Figur 4 ein Blockschaltbild einer erfindungsgemäßen Lösung

Figur 5 eine erste Darstellung zur Erläuterung des Einsatzes der Erfindung

Figur 6 eine zweite Darstellung zur Erläuterung des Einsatzes der Erfindung

Figur 7 eine dritte Darstellung zur Erläuterung des Einsatzes der Erfindung

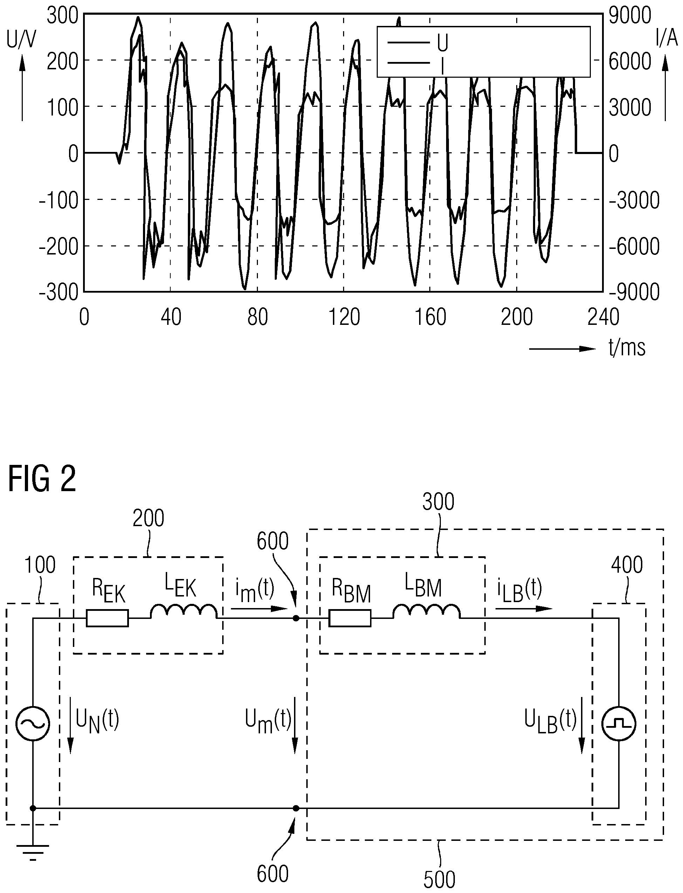

In einem Stromkreis bzw. Netz, in dem ein Störlichtbogen brennt, kann ein Strom- und Spannungsverlauf gemessen werden, der einen signifikanten Verlauf aufweist. Ein typischer Spannungs- und Stromverlauf für einen Störlichtbogen ist in Figur 1 dargestellt. Diese zeigt eine Darstellung eines Diagramms, in dem der zeitliche Verlauf der elektrischen Spannung U und des elektrischen Stromes I nach Zündung eines Lichtbogens bzw. Störlichtbogens, insbesondere parallelen Störlichtbogen, in einem elektrischen Stromkreis, insbesondere Niederspannungsstromkreis, dargestellt ist.

Auf der horizontalen X-Achse ist die Zeit t in Millisekunden (ms) dargestellt. Auf der vertikalen Y-Achse ist auf der linken Skalierung die Größe der elektrischen Spannung U in Volt (V) abgebildet. Auf der rechten Skalierung ist die Größe des elektrischen Stromes I in Ampere (A) abgebildet.

Fortlaufend bzw. periodisch werden elektrische Spannungswerte $u_m$ und elektrische Stromwerte $i_m$ ermittelt, beispielsweise mit je einem Sensor. Dabei kann beispielsweise der elektrische Strom $i_m$ direkt gemessen werden. Alternativ kann auch die Änderung des Stromes nach der Zeit $i'_m$ gemessen werden. Im Falle der Messung des elektrischen Stromes $i_m$ kann daraus die Änderung des Stromes nach der Zeit $i'_m$ ermittelt werden, beispielsweise durch Differentiation des Stromwertes $i_m$.

Im Falle der Messung der Änderung des elektrischen Stromes nach der Zeit $i'_m$ kann daraus der elektrische Strom $i_m$ ermittelt werden, beispielsweise durch Integration der Änderung des elektrischen Stromes nach der Zeit $i'_m$. Die Messung der Änderung des elektrischen Stromes nach der Zeit $i'_m$ kann beispielsweise mit einer Rogowskispule erfolgen. Im Falle sinusförmiger Ströme im Stromkreis ist die Integration besonders einfach zu realisieren, da das Intergral vom Sinus ein Cosinus und vom Cosinus ein Sinus ist.

Ebenso kann der Stromwert $i_m$ und die Änderung des Stromes nach der Zeit $i'_m$ auch parallel, z.B. mit 2 Sensoren, gemessen werden. Damit erübrigt sich eine Umrechnung.

Mit einem zeitlichen Abstand, beispielsweise einem festen zeitlichen Abstand dt, werden immer wieder Spannungswerte $u_m$ und Stromwerte $i_m$ bzw. Spannungswerte $u_m$ und Werte für die Änderung des elektrischen Stromes nach der Zeit $i'_m$ ermittelt. Die Ermittlung kann dabei durch Abtastung der Werte erfolgen. Dabei sollte die Abtastfrequenz bzw. Meßfrequenz ein Vielfaches der Frequenz der gemessenen Wechselgrößen betragen. Beispielsweise könnte bei üblichen Stromnetzen, mit beispielsweise 50 Hz bzw. 60 Hz, die Meßfrequenz im Kilohertz-Bereich liegen, beispielsweise zwischen 1 und 200 kHz, spezifischer im Bereich 10 bis 40 oder 60 kHz, insbesondere im Bereich 40 bis 50 kHz.

Dabei werden beispielsweise ein Spannungswert und eine Stromgröße jeweils zu einem, insbesondere relativ oder konkret gleichen, Zeitpunkt ermittelt.

Figur 2 zeigt ein Ersatzschaltbild eines elektrischen Stromkreises, aufweisend ein elektrische Energiequelle 100, die eine elektrische Netz-Spannung $u_n(t)$ zur Verfügung stellt, ein daran angeschlossenen Netzzugang bzw. ein Einspeise-Kabel 200, dargestellt durch elektrische Ersatzschaltelemente, wie einen Einspeise-Kabel-Widerstand $R_{EK}$ und eine Einspeise-Kabel-Induktivität bzw. Spule $L_{EK}$, dem ein elektrischer Verbraucher, Betriebsmittel bzw. Energiesenke 300 folgt, wiederum dargestellt durch elektrische Ersatzschaltelemente, wie einen Verbraucher-Widerstand $R_{BM}$ und eine Verbraucher-Induktivität bzw. Spule $L_{BM}$. Zwischen Einspeise-Kabel 200 und Verbraucher 300 kann eine elektrische Spannung $u_m(t)$ und eine elektrische Stromgröße, wie der elektrische Stromwert $i_m(t)$ oder/und die Änderung des Stromes nach der Zeit $i'_m(t)$, respektive die erste Ableitung des Stromes nach der Zeit, gemessen werden. Diese Größen werden an den Meßpunkten 600 erfasst, um in der Störlichtbogenerkennungseinheit weiter verarbeitet zu werden.

Der hinsichtlich Störlichtbogen überwachte Bereich ist durch eine gestrichelte Linie 500 dargestellt.

Im elektrischen Stromkreis kann ein Störlichtbogen auftreten, der durch einen Lichtbogen 400 mit einer Lichtbogenspannung

$U_{lb}(t)$ dargestellt ist. Erfindungsgemäß wird fortlaufend eine Lichtbogenspannung $U_{lb}$ in der Störlichtbogenerkennungseinheit mit Hilfe der gemessenen/abgetasteten Spannung $u_m(t)$ und der gemessenen/abgetasteten Stromgröße (Strom oder/und Stromänderung) berechnet.

Erfindungsgemäß wird für die Berechnung die Spannung, der Strom und die Änderung des Stromes nach der Zeit verwendet. Erfindungsgemäß müssen mindestens zwei Wertepaare dieser Größen vorliegen.

Die Berechnung erfolgt dadurch, dass fortlaufend gewisse Terme (mathematische Ausdrücke bzw. Gleichungen) berechnet werden.

Die Berechnung dieser Terme basiert auf einer Lösung der Leitungsgleichung 1.Ordnung:

$$u_m(t) = R_{BM} \cdot i_m(t) + L_{BM} \frac{di_m(t)}{dt} \qquad (1)$$

Unter der Annahme, dass im Niederspannungsnetz ein Störlichtbogen vorhanden ist, so wäre das elektrische Verhalten vergleichbar mit dem einer Gegenspannungsquelle im Netz.

Daraus ergibt sich die folgende, erweiterte Ansatzdifferenzialgleichung:

$$u_m(t) = R_{BM} \cdot i_m(t) + L_{BM} \frac{di_m(t)}{dt} + u_{LB}(t) \qquad (2)$$

Der Störlichtbogen wird vereinfacht als rein ohmscher Verbraucher nachgebildet. Somit wird angenommen, dass die Lichtbogenspannung phasengleich zum Lichtbogenstrom ist. Die Lichtbogenspannung kann somit mit folgender Gleichung beschrieben werden:

$$u_{LB}(t) = U_{LB} \cdot \text{sign}(i_{LB}(t)) \qquad (3)$$

Wird davon ausgegangen, dass der Messstrom $i_m(t)$ dem Störlichtbogenstrom $i_{LB}(t)$ entspricht, also keine Stromverzweigung zwischen Messort und Störlichtbogenbrennstelle vorhanden ist, kann geschrieben werden:

$$u_m(t) = R_{BM} \cdot i_m(t) + L_{BM} \frac{di_m(t)}{dt} + \text{sign}(i_m(t)) \cdot U_{LB} \qquad (4)$$

Zum Lösen dieser erweiterten Ansatzdifferenzialgleichung wird erfindungsgemäß ein differenzierendes Lösungsverfahren verwendet. Die Berechnung der Lichtbogenspannung erfolgt erfindungsgemäß durch Umstellen und Auflösen der Gleichung (4) nach $U_{LB}$.

$$\begin{aligned} u_m(t) &= R_{BM} \cdot i_m(t) + L_{BM} \cdot \frac{di_m(t)}{dt} + U_{LB} \cdot \text{sgn}(i_m(t)) \\ &= R_{BM} \cdot i_m(t) + L_{BM} \cdot i'_m(t) + U_{LB} \cdot \text{sgn}(i_m(t)) \end{aligned} \qquad (5)$$

Eine Vereinfachung der Gleichung lässt sich dadurch erreichen, dass erfindungsgemäß einzelne Komponenten bzw. Elemente der Gleichung nicht berücksichtigt werden. Beispielsweise dass nur die Lichtbogenspannung und die ohmsche bzw. Widerstandskomponente berücksichtigt wird. Alternativ beispielsweise nur die induktive Komponente, induktive plus Vorzeichen des Stromes, ohmsche plus Vorzeichen des Stromes, ohmsche und induktive. In seiner vollständigen Form werden sowohl die ohmsche und induktive Komponente und das Vorzeichen des Stromes berücksichtigt.

Eine solche Vereinfachung hat den besonderen Vorteil, dass dadurch eine besonders einfache Ermittlung der Lichtbogenspannung ermöglicht wird und somit eine einfache Möglichkeit zur Ermittlung eines Störlichtbogen gegeben ist.

Bei Berücksichtigung nicht aller Komponenten lassen sich durch erfindungsgemäße Verwendung zweier unterschiedlicher Wertepaare die Lichtbogenspannung und die entsprechende Komponente berechnen.

Dabei kann beispielsweise die Lichtbogenspannung wie folgt berechnet werden:

$$U_{\text{LB}} = \frac{i_2 \cdot u_1 - i_1 \cdot u_2}{i_2 - i_1} = \frac{P13 - P14}{D9} = \frac{D10}{D9}$$

$$U_{\text{LB}} = \frac{i_2 \cdot u_1 - i_1 \cdot u_2}{\text{sgn}(i_1) \cdot i_2 - \text{sgn}(i_2) \cdot i_1} = \frac{P13 - P14}{D1} = \frac{D10}{D1}$$

$$U_{\text{LB}} = \frac{i''_2 \cdot u_1 - i''_1 \cdot u_2}{i''_2 - i''_1} = \frac{P15 - P16}{D11} = \frac{D12}{D11}$$

$$U_{\text{LB}} = \frac{i'_2 \cdot u_1 - i'_1 \cdot u_2}{\text{sgn}(i_1) \cdot i'_2 - \text{sgn}(i_2) \cdot i'_1} = \frac{P15 - P16}{D13} = \frac{D12}{D13}$$

Durch erfindungsgemäße Verwendung dreier unterschiedlicher Wertepaare lässt sich die Lichtbogenspannung $U_{\text{LB}}$ berechnen.

Die Lichtbogenspannung $U_{\text{LB}}$ lässt sich erfindungsgemäß beispielsweise wie folgt mit einer der nachfolgenden Formeln berechnen:

$$U_{\text{LB}} = \frac{(u_3 i_1 - u_1 i_3)(i'_2 i_1 - i'_1 i_2) - (u_2 i_1 - u_1 i_2)(i'_3 i_1 - i'_1 i_3)}{(i_2 - i_1)(i'_3 i_1 - i'_1 i_3) - (i_3 - i_1)(i'_2 i_1 - i'_1 i_2)}$$

$$U_{\text{LB}} = \frac{(P1 - P2)(P3 - P4) - (P5 - P6)(P7 - P8)}{(D9)(P7 - P8) - (D14)(P3 - P4)} = \frac{D3 * D4 - D5 * D6}{D9 * D6 - D14 * D4}$$

$$U_{\text{LB}} = \frac{P9 - P10}{P17 - P18} = \frac{D7}{D15}$$

Oder:

$$U_{\text{LB}} = \frac{(u_3 i_1 - u_1 i_3)(i'_2 i_1 - i'_1 i_2) - (u_2 i_1 - u_1 i_2)(i'_3 i_1 - i'_1 i_3)}{(\text{sgn}(i_1) i_2 - \text{sgn}(i_2) i_1)(i'_3 i_1 - i'_1 i_3) - (\text{sgn}(i_1) i_3 - \text{sgn}(i_3) i_1)(i'_2 i_1 - i'_1 i_2)} \qquad (6)$$

Wobei $u_1$, $i_1$, $i'_1$ die Spannungs-, Strom- und Stromänderungswerte eines ersten Wertesatzes sind. Die Indizes gelten analog für den zweiten bzw. dritten Wertesatz.

Das Kürzel sgn steht für die Signumfunktion respektive Vorzeichenfunktion. Diese Funktion ordnet einer Zahl ihr Vorzeichen zu. Diese ist wie folgt definiert:

```
sgn(x) = +1, falls x>0;

sgn(x) = 0, falls x=0;

sgn(x) = -1, falls x<0.
```

Die Formel 6 besteht aus zwei Differenzen D1, D2, aus mehreren Produkten P1,...,P8, die wiederum die Basis für Differenzen D3 bis D6 bilden. Diese können wiederum zu Produkten P9,...,P12 zusammengefasst werden. Diese Produkte bilden die Basis für zwei weitere Differenzen D7, D8, mit deren Hilfe die Lichtbogenspannung berechnet werden kann. Formel 6 kann wie folgt umgeschrieben werden:

$$U_{LB} = \frac{(P1 - P2)(P3 - P4) - (P5 - P6)(P7 - P8)}{(D1)(P7 - P8) - (D2)(P3 - P4)} \tag{7}$$

$$U_{LB} = \frac{D3 * D4 - D5 * D6}{D1 * D6 - D2 * D4} \tag{8}$$

$$U_{LB} = \frac{P9 - P10}{P11 - P12} \tag{9}$$

$$U_{LB} = \frac{D7}{D8} \tag{10}$$

Für eine sichere Detektion eines Störlichtbogens ist es notwendig, den Betriebsfall - Anlage ohne Störlichtbogen - vom Fehlerfall - Anlage mit Störlichtbogen - abzugrenzen. Mit der vorliegenden Erfindung wird die Störlichtbogenspannung $U_{LB}$ berechnet. Mit einem darauf folgenden Schwellwertvergleich der ermittelten Lichtbogenspannung wird die Unterscheidung zwischen den Zuständen: a) Störlichtbogen vorhanden und b) Kein Störlichtbogen vorhanden, getroffen.

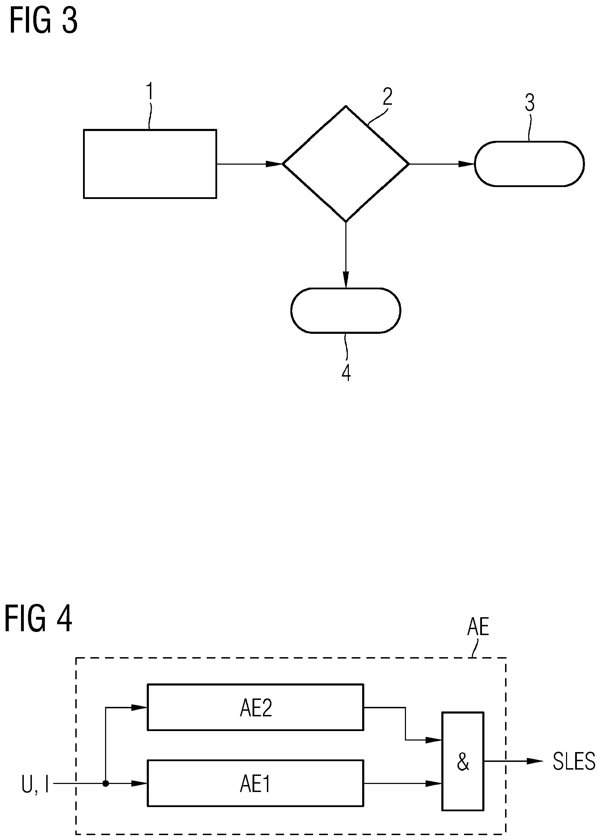

In Figur 3 ist ein derartiges Diagramm dargestellt. In einem ersten Schritt 1 erfolgt die fortlaufende Berechnung der Lichtbogenspannung.

In einem zweiten Schritt 2 wird diese jeweils mit dem Schwellwert SW verglichen.

Erfolgt eine Überschreitung des Schwellwertes SW, wird in einem dritten Schritt 3 die Erkennung eines Störlichtbogens angezeigt und/oder ein Störlichtbogenerkennungssignals abgegeben.

Ist der Schwellwert SW nicht überschritten, kann in einem vierten Schritt 4 die Meldung, dass kein Störlichtbogen vorhanden ist, erfolgen.

Beispielsweise kann der Schwellwert SW bzw. dessen Betrag geeignet festgelegt werden, z.B. bei 30 Volt.

Ausgehend von etwa 10-20 V für den Anoden-Kathodenfall beruht die Annahme darauf, dass noch etwa 10 V zusätzlich für die Lichtbogensäule benötigt werden.

Allgemein gesagt kann der Schwellwert für ein, insbesondere 400 Volt, Niederspannungsnetz im Bereich 20 bis 300 Volt liegen, spezifischer im Bereich 20 bis 70 Volt. Insbesondere Werte von 25 bis 50 Volt scheinen gut geeignet zu sein.

Die erfindungsgemäße Störlichtbogenerkennung kann mit weiteren Kriterien kombiniert werden. Beispielsweise mit einem weiteren Vergleich der Höhe des elektrischen Stromes des Stromkreises. Der gemessene Strom, insbesondere der Effektivwert des gemessenen Stromes, der beispielsweise nach der Methode von Mann-Morrison berechnet werden kann, wird dabei mit einem zweiten Schwellwert SW2 bzw. Stromschwellwert verglichen und nur wenn dieser zweite Schwellwert SW2 bzw. Stromschwellwert überschritten ist und die berechnete Lichtbogenspannung den Schwellwert SW überschreitet, wird ein Störlichtbogenerkennungssignal abgegeben.

Diese als Überstromfreigabe bezeichnetes Kriterium führt zu einer sicheren Fehlerabgrenzung. Für die Störlichtbogenerkennung muss ein minimaler Störlichtbogenstrom im Stromkreis fließen, um ein Störlichtbogenerkennungssignal zu bewirken. Als Schwellwert für die Überstromfreigabe kann ein vom Betriebsstrom abhängiger Wert gewählt werden. Alternativ könnte die Schwellwertfestlegung auch lichtbogenspezifisch erfolgen, da für einen brennenden, beispielsweise parallelen, Niederspannungslichtbogen ein Lichtbogenstrom von üblicherweise 1000 A vorliegt. Bei seriellen Lichtbögen liegen weitaus geringere Ströme vor. D.h. der zweite Schwellwert SW2 kann je nach Einsatz bzw. Anwendung jeden Wert ab beispielsweise 1 A, 10 A, 100 A, 1000 A oder 5000 A annehmen.

Die Verknüpfung zwischen Überstromfreigabe und der erfindungsgemäßen Lichtbogenspannungsberechnung ist in Figur 4 dargestellt.

Figur 4 zeigt eine Darstellung, bei der die ermittelte Spannung U und die ermittelte Stromgröße des Stromkreises einer ersten Auswerteeinheit AE1, zur Ermittlung der Lichtbogenspannung zugeführt wird.

Die ermittelte Stromgröße des Stromkreises wird einer zweiten Auswerteeinheit AE2, zur Prüfung des Stromkriteriums, zugeführt.

Die Ausgänge der der beiden Auswerteeinheiten AE1, AE2 sind mit einer UND-Einheit & verknüpft, dessen Ausgang bei Erfüllung der Kriterien ein Störlichtbogenerkennungssignal SLES abgibt.

Die drei Auswerteeinheiten können dabei als Teileinheiten bzw. Untereinheiten in einer Auswerteeinheit AE angeordnet sein.

Des Weiteren kann die Abgabe eines Störlichtbogenerkennungssignals erst dann erfolgen, wenn mindestens zweimal die Lichtbogenspannung oder/und das Stromkriterium den entsprechenden Schwellwert überschreitet. Analog kann auch eine dreimalige, viermalige, fünfmalige, usw. Überschreitung des Schwellwertes zur Abgabe eines Störlichtbogenerkennungssignales führen. So wird eine besonders sichere Auswertung und Erkennung eines Störlichtbogens erreicht.

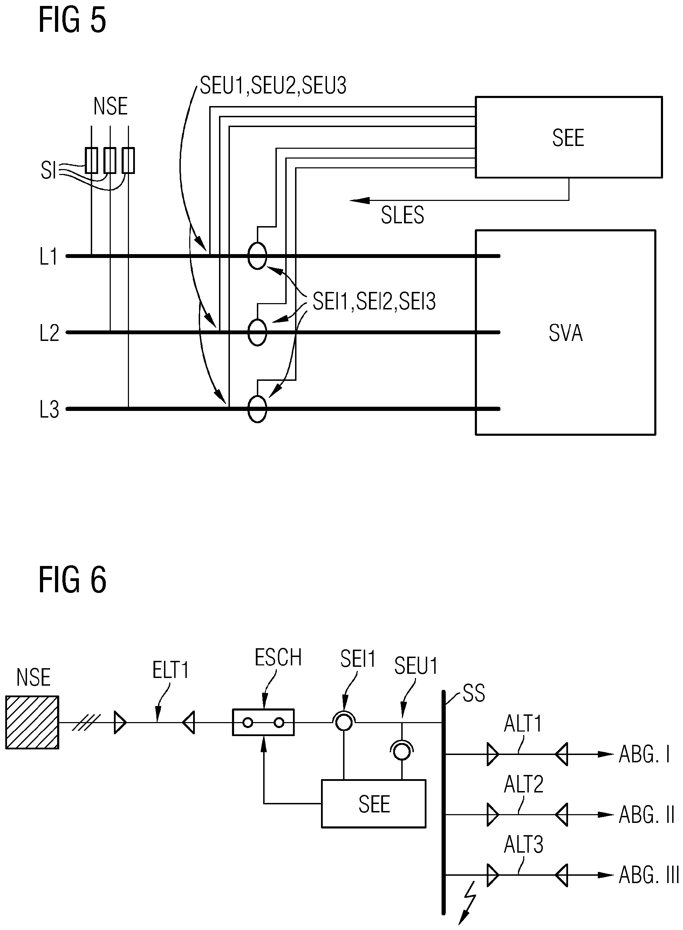

Figur 5 zeigt eine schematische Darstellung eines Übersichtsschaltbildes für eine Anlagenkonfiguration mit abgangsselektiver Störlichtbogenerkennungseinheit für die Erfassung von Störlichtbogen. Figur 5 zeigt eine NiederspannungsEinspeisung NSE, mit Sicherungen SI, denen Stromschienen bzw. Sammelschienen L1, L2, L3 für die Leiter eines Dreiphasen-Wechselstromnetzes bzw. Stromkreises folgen. Der Neutralleiter bzw. Nullleiter ist nicht dargestellt. Jeder der drei Stromschienen L1, L2, L3 ist jeweils ein Spannungssensor SEU1, SEU2, SEU3 und ein Stromsensor SEI1, SEI2, SEI3 zugeordnet. Die Stromschienen sind mit einer Schalt- oder/und Verteilanlage SVA verbunden.

Die Spannungs- und Stromsensoren sind mit einer erfindungsgemäßen Störlichtbogenerkennungseinheit SEE verbunden, die eine erfindungsgemäße Auswerteeinheit AE aufweist. Diese weist einen Ausgang zur Abgabe eines Störlichtbogenerkennungssignals SLES auf.

Die Spannungs- und Stromsensoren ermitteln Spannungswerte und Stromgrößen (Stromwert oder/und Stromwertänderung) der Sammelschienen L1, L2, L3 und führen sie der erfindungsgemäßen Störlichtbogenerkennungseinheit SEE zu.

Die Sensoren sind dabei außerhalb Störlichtbogenerkennungseinheit angeordnet und mit dieser verbunden.

Figur 6 zeigt eine weitere schematische Darstellung eines Übersichtsschaltbildes für eine Anlagenkonfiguration mit zentraler Störlichtbogenerkennungseinheit für die Erfassung von Störlichtbogen. Figur 6 zeigt eine Niederspannungseinspeisung NSE, der ein Einspeise-Kabel ELT1 folgt, dem ein Einspeise-Schalter ESCH folgt, dem ein Stromsensor SEI1 und ein Spannungssensor SEU1 folgt, dem eine Sammelschiene SS folgt. An der Sammelschiene SS sind 3 Abgänge ABG I ABG II und ABG III vorgesehen. Diesen ist je ein Abgangs-Kabel ALT1, ALT2, ALT3 zugeordnet.

Die Sensoren SEI1, SEU1 sind mit einer Störlichtbogenerkennungseinheit SEE verbunden, dessen Ausgang wiederum mit dem Einspeise-Schalter ESCH verbunden ist. Der Einspeise-Schalter kann dabei ein Leistungsschalter sein. Bei Erkennung eines Störlichtbogens kann der elektrische Stromkreis, d.h. die Stromversorgung der Sammelschiene SS unterbrochen werden, wenn beispielsweise in einem der Abgänge ein Störlichtbogen auftritt.

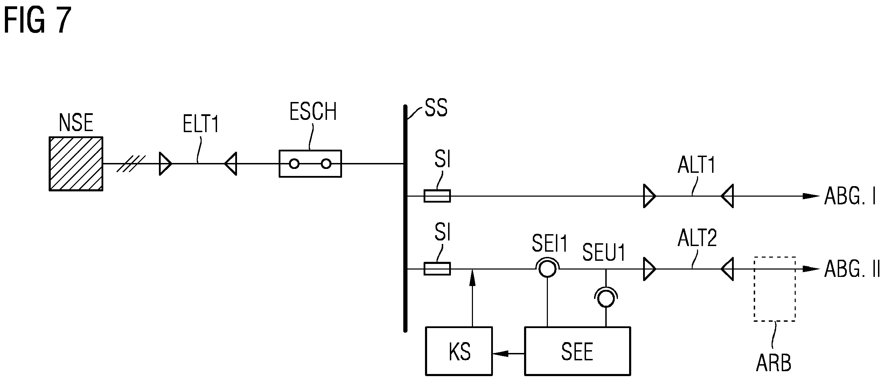

Figur 7 zeigt eine Darstellung gemäß Figur 6, mit dem Unterschied, dass die Sensoren im zweiten Abgang ABG II angeordnet sind, der zudem Sicherungen SI und einen Kurzschließer KS aufweist. Die Sensoren SEI1 und SEU1 erfassen Strom- und Spannungswerte des Abganges ABG II und geben diese an die Störlichtbogenerkennungseinheit SEE weiter. Erkennt die Störlichtbogenerkennungseinheit SEE einen Störlichtbogen, wird an ihrem Ausgang ein Störlichtbogenerkennungssignal abgegeben und zum Kurzschließer KS übertragen. Dieser schließt daraufhin den Abgang ABG II kurz, um den Störlichtbogen zu löschen.

Die Störlichtbogenerkennung gemäß Figur 6 oder 7 kann beispielsweise als mobiles System ausgeführt sein.

Die Erfindung soll im Folgenden nochmals erläutert werden.

Mit der Erfindung können Störlichtbögen, insbesondere parallele oder stromstarke, insbesondere in Niederspannungsschalt- und Verteilungsanlagen, erkannt werden. Erfindungsgemäß steht dazu insbesondere eine nummerischer Lösung bzw. Detektionsalgorithmus auf Grundlage der Auswertung von gemessenen Spannungs- und Stromwerten bzw. -signalen zur Verfügung. Für die Erkennung von Störlichtbögen wird die Spannung und der Strom bzw. Änderung des Stromes gemessen und Mithilfe einer erfindungsgemäßen Lichtbogenspannungsberechnung ein Störlichtbogen ermittelt. Aufgrund der in der Praxis notwendigen schnellen Lichtbogendetektion kann hierbei erfindungsgemäß eine außerordentlich schnelle zeitliche Auswertung zur Verfügung gestellt werden.

Mit dieser Erfindung können beispielsweise auf Basis einer zentralen Spannungs- und Strommessung an der Einspeisung Störlichtbögen, beispielsweise in Schalt- und Verteileranlagen, z.B. in der Niederspannung, schnell detektiert werden.

Die Erfindung kann insbesondere vorteilhaft in bzw. im Zusammenwirken mit Leistungsschaltern oder Kurzschließern eingesetzt werden.

Eine aufwendige Installation von Lichtwellenleitern in Anlagen zur Störlichtbogenerkennung ist nicht erforderlich. Die Spannungs- / Strommessung kann zentral realisiert und ggf. synergetisch von weiteren Betriebsmitteln genutzt werden.

Im Weiteren ist eine Implementierung in vorhandene Schalt- und Verteileranalgen einfach möglich, da ein erfindungsgemäßes Detektionssystem beispielsweise lediglich zentral eingebaut werden kann und keine Installation in einzelnen, zu schützenden Zellen erforderlich ist.

Die Erfindung kann als Baugruppe mit zentraler Spannungs- und Stromermittlung realisiert sein.

Die bisher am Markt etablierten Detektionssysteme basieren auf einer optischen Fehlererkennung und weisen somit Potential zu einer Fehlauslösung durch die Einwirkung von Fremdlicht (z.B. Blitzlicht) auf. Bei der erfindungsgemäßen Lösung auf Grundlage einer Spannungs- und Strommessung ist dieses Gefahrenpotential nicht vorhanden.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| | |
|---|---|
| A | Ampere |
| ABG I | Abgang I |
| ABG II | Abgang II |
| ABG III | Abgang III |
| ALT 1 | Abgangs-Kabel 1 |
| ALT 2 | Abgangs-Kabel 2 |
| ALT 3 | Abgangs-Kabel 3 |
| ARB | Arbeitsbereich |
| AE | Auswerteeinheit |
| AE1 | Erste Auswerte(teil)einheit |
| AE2 | Zweite Auswerte(teil)einheit |
| ELT1 | Einspeise-Kabel 1 |
| ESCH | Einspeise-Schalter, Leistungsschalter |
| I | elektrischer Strom |
| $i_{lb}$ | Lichtbogenstrom |
| $i_m$ | Stromwert, gemessen |
| $i'_m$ | Wert der Änderung des Stromwertes |
| KS | Kurzschließer |
| $L_{BM}$ | Induktivität Verbraucher |
| $L_{EK}$ | Induktivität Einspeise-Kabel |
| L1 | Stromschiene, Leiter 1 |
| L2 | Stromschiene, Leiter 2 |
| L3 | Stromschiene, Leiter 3 |
| ms | Millisekunden |
| NSE | Niederspannungseinspeisung |
| $R_{BM}$ | Widerstand Verbraucher |
| $R_{EK}$ | Widerstand Einspeise-Kabel |
| SEE | Störlichtbogenerkennungseinheit |
| SEI1 | Stromsensor |
| SEI2 | Stromsensor |
| SEI3 | Stromsensor |
| SEU1 | Spannungssensor |
| SEU2 | Spannungssensor |
| SEU3 | Spannungssensor |
| SLES | Störlichtbogenerkennungssignal |
| SI | Sicherung |
| SS | Sammelschiene |
| SVA | Schalt- und Verteilanlage |
| SW | Schwellwert Lichtbogenspannung |
| SW2 | Zweiter Schwellwert Stromfreigabe |
| t | Zeit |
| U | elektrische Spannung |
| $U_{lb}$ | Lichtbogenspannung |
| $u_m$ | Spannungswert, gemessen |
| $u_n$ | Spannungswert, Energiequelle / Netz |
| V | Volt |
| & | UND-Einheit |
| 1 | Schritt 1 - fortlauf. Berechnung Lichtbogenspannung |
| 2 | Schritt 2 - Schwellwertvergleich |
| 3 | Schritt 3 - Abgabe Störlichtbogenerkennungssignal |
| 4 | Schritt 4 - Kein Störlichtbogen |
| 100 | Energiequelle |
| 200 | Netzzugang / Einspeise-Kabel |
| 300 | Verbraucher / Betriebsmittel / Energiesenke |

| 400 | Lichtbogen |
|---|---|
| 500 | Überwachter Bereich |
| 600 | Meßpunkte |

**Patentansprüche**

1. Störlichtbogenerkennungseinheit (SEE) für einen elektrischen Niederspannungsstromkreis, aufweisend

mindestens einen dem Stromkreis zugeordneten Spannungssensor (SEU), zur periodischen Ermittlung von elektrischen Spannungswerten ($u_m$) des Stromkreises,
mindestens einen dem Stromkreis zugeordneten Stromsensor (SEI), zur periodischen Ermittlung von elektrischen Stromgrößen des Stromkreises,
die beide mit einer Auswerteeinheit (AE) verbunden sind, und die derart ausgestaltet sind,
dass fortlaufend Wertepaare eines Spannungswertes ($u_m$) und einer Stromgröße zu einem Zeitpunkt ermittelt werden, so dass jeweils
ein erstes Wertepaar eines Spannungswertes ($u_1$) und einer Stromgröße zu einem ersten Zeitpunkt und
ein zweites Wertepaar eines Spannungswertes ($u_2$) und einer Stromgröße zu einem zweiten Zeitpunkt vorliegen,
dadurch
dass aus den zwei Wertepaaren eine Lichtbogenspannung ($U_{lb}$) eines gezündeten Lichtbogens berechnet wird, die mit einem Schwellwert (SW) verglichen wird und bei dessen betragsmäßiger Überschreitung ein Störlichtbogenerkennungssignal (SLES) abgegeben wird.

2. Störlichtbogenerkennungseinheit nach Patentanspruch 1, **dadurch gekennzeichnet,**

**dass** ein drittes Wertepaar eines Spannungswertes ($u_3$) und einer Stromgröße zu einem dritten Zeitpunkt vorliegt,
**dass** aus den drei Wertepaaren eine Lichtbogenspannung ($U_{lb}$) berechnet wird, die mit einem Schwellwert (SW) verglichen wird und bei dessen betragsmäßiger Überschreitung ein Störlichtbogenerkennungssignal (SLES) abgegeben wird.

3. Störlichtbogenerkennungseinheit nach Patentanspruch 1 oder 2,
**dadurch gekennzeichnet,**
**dass** als elektrische Stromgröße entweder ein elektrischer Stromwert ($i_m$) oder/und ein Wert für die Änderung des elektrischen Stromes nach der Zeit ($i'_m$) ermittelt wird.

4. Störlichtbogenerkennungseinheit nach Patentanspruch 3, **dadurch gekennzeichnet,**

**dass** im Falle der Ermittlung des elektrischen Stromwertes ($i_m$) daraus ein Wert für die Änderung des elektrischen Stromes nach der Zeit ($i'_m$) ermittelt wird oder
**dass** im Falle der Ermittlung des Wertes für die Änderung des elektrischen Stromes nach der Zeit ($i'_m$) daraus der elektrische Stromwert ($i_m$) ermittelt wird,
so dass das Wertepaar einen Spannungswert ($u_m$), einen Stromwert ($i_m$) und einen Wert für die Änderung des Stromes nach der Zeit ($i'_m$) aufweist.

5. Störlichtbogenerkennungseinheit nach Patentanspruch 1, 2, 3 oder 4,
**dadurch gekennzeichnet,**
**dass** die Auswerteeinheit (AE) derart ausgestaltet ist, dass die Berechnung der Lichtbogenspannung ($U_{lb}$) mit Hilfe einer Differentialgleichung oder deren Lösung durchgeführt wird.

6. Störlichtbogenerkennungseinheit nach Patentanspruch 1, 2, 3, 4 oder 5,
**dadurch gekennzeichnet,**
**dass** für die Berechnung der Lichtbogenspannung ($U_{lb}$) mindestens einer der folgenden Terme gebildet wird:

ein dreizehntes Produkt (P13), gebildet aus dem zweiten Stromwert ($i_2$) und dem ersten Spannungswert ($u_1$),
ein vierzehntes Produkt (P14), gebildet aus dem ersten Stromwert ($i_1$) und dem zweiten Spannungswert ($u_2$),
eine neunte Differenz (D9), dessen Minuend der zweite Stromwert ($i_2$) und dessen Subtrahend der erste Stromwert ($i_1$) ist,

eine zehnte Differenz (D10), dessen Minuend das dreizehnte Produkt (P13) und dessen Subtrahend das vierzehnte Produkt (P14) ist.

7. Störlichtbogenerkennungseinheit nach Patentanspruch 6, **dadurch gekennzeichnet,**
**dass** die Lichtbogenspannung ($U_{lb}$) ein Quotient ist,
dessen Dividend Terme der zehnten Differenz (D10) aufweist und dessen Divisor Terme der neunten Differenz (D9) aufweist.

8. Störlichtbogenerkennungseinheit nach Patentanspruch 1 bis 6,
**dadurch gekennzeichnet,**
**dass** für die Berechnung der Lichtbogenspannung ($U_{lb}$) mindestens einer der folgenden Terme gebildet wird:

ein erstes Produkt (P1), gebildet aus dem dritten Spannungswert ($u_3$) und dem ersten Stromwert ($i_1$),
ein zweites Produkt (P2), gebildet aus dem ersten Spannungswert ($u_1$) und dem dritten Stromwert ($i_3$),
ein drittes Produkt (P3), gebildet aus dem Wert der Änderung des zweiten Stromwertes nach der Zeit (i'2) und dem ersten Stromwert ($i_1$) ,
ein viertes Produkt (P4), gebildet aus dem Wert der Änderung des ersten Stromwertes nach der Zeit (i'1) und dem zweiten Stromwert ($i_2$) ,
ein fünftes Produkt (P5), gebildet aus dem zweiten Spannungswert (u2) und dem ersten Stromwert ($i_1$),
ein sechstes Produkt (P6), gebildet aus dem ersten Spannungswert ($u_1$) und dem zweiten Stromwert ($i_2$),
ein siebtes Produkt (P7), gebildet aus dem Wert der Änderung des dritten Stromwertes nach der Zeit (i'3) und dem ersten Stromwert ($i_1$),
ein achtes Produkt (P8), gebildet aus dem Wert der Änderung des ersten Stromwertes nach der Zeit (i'$_1$) und dem dritten Stromwert ($i_3$),
eine erste Differenz (D1), dessen Minuend aus dem Produkt des Vorzeichens des ersten Stromwertes ($sgn(i_1)$) und dem zweiten Stromwert ($i_2$) und dessen Subtrahend aus dem Produkt des Vorzeichens des zweiten Stromwertes ($sgn(i_2)$) und dem ersten Stromwert ($i_1$) gebildet wird,
ein zweite Differenz (D2), dessen Minuend aus dem Produkt des Vorzeichens des ersten Stromwertes ($sgn(i_1)$) und dem dritten Stromwert ($i_3$) und dessen Subtrahend aus dem Produkt des Vorzeichens des dritten Stromwertes ($sgn(i_3)$) und dem ersten Stromwert ($i_1$) gebildet wird.

9. Störlichtbogenerkennungseinheit nach Patentanspruch 8, **dadurch gekennzeichnet,**
**dass** die Lichtbogenspannung ($U_{lb}$) ein Quotient ist,
dessen Dividend Terme der zehnten Differenz (D10) aufweist und dessen Divisor Terme der erste Differenz (D1) aufweist.

10. Störlichtbogenerkennungseinheit nach Patentanspruch 1 bis 6 oder 8,
**dadurch gekennzeichnet,**
**dass** für die Berechnung der Lichtbogenspannung ($U_{lb}$) mindestens einer der folgenden Terme gebildet wird:

ein fünfzehntes Produkt (P15), gebildet aus dem Wert der Änderung des zweiten Stromwertes (i'2) und dem ersten Spannungswert ($u_1$),
ein sechzehntes Produkt (P16), gebildet aus dem Wert der Änderung des ersten Stromwertes (i'$_1$) und dem zweiten Spannungswert ($u_2$),
eine elfte Differenz (D11), dessen Minuend der Wert der Änderung des zweiten Stromwertes (i'2) und dessen Subtrahend der Wert der Änderung des ersten Stromwertes (i'$_1$) ist,
eine zwölfte Differenz (D12), dessen Minuend das fünfzehnte Produkt (P15) und dessen Subtrahend das sechzehnte Produkt (P16) ist.

11. Störlichtbogenerkennungseinheit nach Patentanspruch 10, **dadurch gekennzeichnet,**
**dass** die Lichtbogenspannung ($U_{lb}$) ein Quotient ist,
dessen Dividend Terme der zwölften Differenz (D12) aufweist und dessen Divisor Terme der elften Differenz (D11) aufweist.

12. Störlichtbogenerkennungseinheit nach Patentanspruch 1 bis 6, 8 oder 10,
**dadurch gekennzeichnet,**
**dass** für die Berechnung der Lichtbogenspannung ($U_{lb}$) mindestens einer der folgenden Terme gebildet wird:
eine dreizehnte Differenz (D13), dessen Minuend aus dem Produkt des Vorzeichens des ersten Stromwertes ($sgn(i_1)$)

und dem Wert der Änderung des zweiten Stromwertes (i'2) und dessen Subtrahend aus dem Produkt des Vorzeichens des zweiten Stromwertes (sgn(i₂)) und dem Wert der Änderung des ersten Stromwertes (i'₁) gebildet wird.

13. Störlichtbogenerkennungseinheit nach Patentanspruch 12, **dadurch gekennzeichnet,**
**dass** die Lichtbogenspannung ($U_{lb}$) ein Quotient ist,
dessen Dividend Terme der zwölften Differenz (D12) aufweist und dessen Divisor Terme der dreizehnten Differenz (D13) aufweist.

14. Störlichtbogenerkennungseinheit nach Patentanspruch 1 bis 6, 8, 10 oder 12,
**dadurch gekennzeichnet,**
**dass** für die Berechnung der Lichtbogenspannung ($U_{lb}$) mindestens einer der folgenden Terme gebildet wird:

eine dritte Differenz (D3), dessen Minuend das erste Produkt (P1) und dessen Subtrahend das zweite Produkt (P2) ist,
eine vierte Differenz (D4), dessen Minuend das dritte Produkt (P3) und dessen Subtrahend das vierte Produkt (P4) ist,
eine fünfte Differenz (D5), dessen Minuend das fünfte Produkt (P5) und dessen Subtrahend das sechste Produkt (P6) ist,
eine sechste Differenz (D6), dessen Minuend das siebte Produkt (P7) und dessen Subtrahend das achte Produkt (P8) ist.

15. Störlichtbogenerkennungseinheit nach Patentanspruch 14, **dadurch gekennzeichnet,**
**dass** für die Berechnung der Lichtbogenspannung ($U_{lb}$) mindestens einer der folgenden Terme gebildet wird:

ein neuntes Produkt (P9), gebildet aus der dritten Differenz (D3) und der vierten Differenz (D4),
ein zehntes Produkt (P10), gebildet aus der fünften Differenz (D5) und der sechsten Differenz (D6),
ein elftes Produkt (P11), gebildet aus der ersten Differenz (D1) und der sechsten Differenz (D6),
ein zwölftes Produkt (P12), gebildet aus der zweiten Differenz (D2) und der vierten Differenz (D4).

16. Störlichtbogenerkennungseinheit nach Patentanspruch 15, **dadurch gekennzeichnet,**
**dass** für die Berechnung der Lichtbogenspannung ($U_{lb}$) mindestens einer der folgenden Terme gebildet wird:

eine siebte Differenz (D7), dessen Minuend das neunte Produkt (P9) und dessen Subtrahend das zehnte Produkt (P10) ist,
eine achte Differenz (D8), dessen Minuend das elfte Produkt (P11) und dessen Subtrahend das zwölfte Produkt (P12) ist.

17. Störlichtbogenerkennungseinheit nach Patentanspruch 16, **dadurch gekennzeichnet,**
**dass** die Lichtbogenspannung ($U_{lb}$) ein Quotient ist,
dessen Dividend Terme der siebten Differenz (D7) aufweist und dessen Divisor Terme der achten Differenz (D8) aufweist.

18. Störlichtbogenerkennungseinheit nach Patentanspruch 1 bis 6, 8, 10, 12, 14, 15 oder 16,
**dadurch gekennzeichnet,**
**dass** für die Berechnung der Lichtbogenspannung ($U_{lb}$) mindestens einer der folgenden Terme gebildet wird:

eine vierzehnte Differenz (D14), dessen Minuend der dritte Stromwert (i₃) und dessen Subtrahend der erste Stromwert (i₁) ist,
ein siebzehntes Produkt (P17), gebildet aus der neunten Differenz (D9) und der sechsten Differenz (D6),
ein achtzehntes Produkt (P18), gebildet aus der vierzehnten Differenz (D14) und der vierten Differenz (D4),
eine fünfzehnte Differenz (D15), dessen Minuend das siebzehnte Produkt (P17) und dessen Subtrahend der achtzehnte Produkt (P18) ist.

19. Störlichtbogenerkennungseinheit nach Patentanspruch 18, **dadurch gekennzeichnet,**
**dass** die Lichtbogenspannung ($U_{lb}$) ein Quotient ist,
dessen Dividend Terme der siebten Differenz (D7) aufweist und dessen Divisor Terme der fünfzehnten Differenz (D15) aufweist.

20. Störlichtbogenerkennungseinheit nach einem der vorhergehenden Patentansprüche, **dadurch gekennzeichnet,**

**dass** der erste Zeitpunkt zeitlich vor dem zweiten Zeitpunkt liegt oder
**dass** der zweite Zeitpunkt zeitlich vor dem dritten Zeitpunkt liegt oder
**dass** der erste Zeitpunkt zeitlich vor dem zweiten Zeitpunkt liegt und dieser zeitlich vor dem dritten Zeitpunkt liegt.

21. Störlichtbogenerkennungseinheit nach einem der vorhergehenden Patentansprüche, **dadurch gekennzeichnet,**
**dass** die Auswerteeinheit derart ausgestaltet ist, dass ein Störlichtbogenerkennungssignal (SLES) nur dann abgegeben wird, wenn die Stromgröße, insbesondere der Stromwert, einen zweiten Schwellwert (SW2) überschreit.

22. Leistungsschalter, aufweisend eine Störlichtbogenerkennungseinheit nach einem der Patentansprüche 1 bis 21, die mit dem Leistungsschalter verbunden ist und die derart ausgestaltet sind, dass bei einem Störlichtbogenerkennungssignal (SLES) der elektrische Stromkreis durch den Leistungsschalter unterbrochen wird.

23. Kurzschließer, aufweisend eine Störlichtbogenerkennungseinheit nach einem der Patentansprüche 1 bis 21, die mit dem Kurzschließer verbunden ist und die derart ausgestaltet sind, dass bei einem Störlichtbogenerkennungssignal (SLES) der elektrische Stromkreis durch den Kurzschließer kurzgeschlossen wird, um ein Löschen des Störlichtbogen zu bewirken.

24. Verfahren zur Störlichtbogenerkennung für einen elektrischen Niederspannungsstromkreis, bei dem periodisch elektrische Spannungswerte und Stromgrößen des Stromkreises ermittelt werden, so dass jeweils

ein erstes Wertepaar eines Spannungswertes ($u_1$) und einer Stromgröße zu einem ersten Zeitpunkt und
ein zweites Wertepaar eines Spannungswertes ($u_2$) und einer Stromgröße zu einem zweiten Zeitpunkt vorliegt,
dass aus den zwei Wertepaaren eine Lichtbogenspannung ($U_{lb}$) eines gezündeten Lichtbogens berechnet wird,
die mit einem Schwellwert (SW) verglichen wird und bei dessen Überschreitung ein Störlichtbogenerkennungssignal (SLES) abgegeben wird.

**Claims**

1. Arc fault detection unit (SEE) for an electrical low-voltage circuit, having

at least one voltage sensor (SEU) assigned to the circuit, for periodically determining electrical voltage values ($u_m$) of the circuit,
at least one current sensor (SEI) assigned to the circuit, for periodically determining electrical current magnitudes of the circuit,
both of which are connected to an evaluation unit (AE) and which are embodied in such a way
that value pairs of a voltage value ($u_m$) and of a current magnitude are determined continuously at a point in time, so that in each case
a first value pair of a voltage value ($u_1$) and of a current magnitude is present at a first point in time, and
a second value pair of a voltage value ($u_2$) and of a current magnitude is present at a second point in time,
**characterized in that** an arc voltage ($U_{lb}$) of an ignited arc, which is compared to a threshold value (SW), is calculated from the two value pairs and if said threshold value is exceeded in magnitude, an arc fault detection signal (SLES) is output.

2. Arc fault detection unit according to Patent Claim 1, **characterized**

**in that** a third value pair of a voltage value ($u_3$) and of a current magnitude is present at a third point in time,
**in that** an arc voltage ($U_{1b}$), which is compared to a threshold value (SW), is calculated from the three value pairs and if said threshold value is exceeded in magnitude, an arc fault detection signal (SLES) is output.

3. Arc fault detection unit according to Patent Claim 1 or 2, **characterized**
**in that** either an electrical current value ($i_m$) and/or a value for the change of the electrical current with respect to time ($i'_m$) is determined as electrical current magnitude.

**4.** Arc fault detection unit according to Patent Claim 3, **characterized**

**in that** if the electrical current value ($i_m$) is determined, a value for the change of the electrical current with respect to time ($i'_m$) is determined therefrom or
**in that** if the value for the change of the electrical current with respect to time ($i'_m$) is determined, the electrical current value ($i_m$) is determined therefrom,
so that the value pair has a voltage value ($u_m$), a current value ($i_m$) and a value for the change of the current with respect to time ($i'_m$).

**5.** Arc fault detection unit according to Patent Claim 1, 2, 3 or 4, **characterized**
**in that** the evaluation unit (AE) is embodied in such a way that the calculation of the arc voltage ($U_{lb}$) is carried out with the help of a differential equation or the solution thereof.

**6.** Arc fault detection unit according to Patent Claim 1, 2, 3, 4 or 5, **characterized**
**in that** at least one of the following terms is formed for calculating the arc voltage ($U_{lb}$):

a thirteenth product (P13), formed from the second current value ($i_2$) and the first voltage value ($u_1$),
a fourteenth product (P14), formed from the first current value ($i_1$) and the second voltage value ($u_2$),
a ninth difference (D9), the minuend of which is the second current value ($i_2$) and the subtrahend of which is the first current value ($i_1$),
a tenth difference (D10), the minuend of which is the thirteenth product (P13) and the subtrahend of which is the fourteenth product (P14).

**7.** Arc fault detection unit according to Patent Claim 6, **characterized**
**in that** the arc voltage ($U_{lb}$) is a quotient,
the dividend of which has terms of the tenth difference (D10) and the divisor of which has terms of the ninth difference (D9).

**8.** Arc fault detection unit according to Patent Claims 1 to 6, **characterized**
**in that** at least one of the following terms is formed for calculating the arc voltage ($U_{lb}$):

a first product (P1), formed from the third voltage value ($u_3$) and the first current value ($i_1$),
a second product (P2), formed from the first voltage value ($u_1$) and the third current value ($i_3$),
a third product (P3), formed from the value of the change of the second current value with respect to time ($i'_2$) and the first current value ($i_1$),
a fourth product (P4), formed from the value of the change of the first current value with respect to time ($i'_1$) and the second current value ($i_2$),
a fifth product (P5), formed from the second voltage value ($u_2$) and the first current value ($i_1$),
a sixth product (P6), formed from the first voltage value ($u_1$) and the second current value ($i_2$),
a seventh product (P7), formed from the value of the change of the third current value with respect to time ($i'_3$) and the first current value ($i_1$),
an eighth product (P8), formed from the value of the change of the first current value with respect to time ($i'_1$) and the third current value ($i_3$),
a first difference (D1), the minuend of which is formed from the product of the sign of the first current value (sgn(ii)) and the second current value ($i_2$) and the subtrahend of which is formed from the product of the sign of the second current value (sgn($i_2$)) and the first current value ($i_1$),
a second difference (D2), the minuend of which is formed from the product of the sign of the first current value (sgn(ii)) and the third current value ($i_3$) and the subtrahend of which is formed from the product of the sign of the third current value (sgn($i_3$)) and the first current value ($i_1$).

**9.** Arc fault detection unit according to Patent Claim 8, **characterized**
**in that** the arc voltage ($U_{lb}$) is a quotient,
the dividend of which has terms of the tenth difference (D10) and the divisor of which has terms of the first difference (D1).

**10.** Arc fault detection unit according to Patent Claims 1 to 6 or 8, **characterized in that** at least one of the following terms is formed for the calculation of the arc voltage ($U_{lb}$):

a fifteenth product (P15), formed from the value of the change of the second current value ($i'_2$) and the first voltage value ($u_1$) ,
a sixteenth product (P16), formed from the value of the change of the first current value ($i'_1$) and the second voltage value ($u_2$),
an eleventh difference (D11), the minuend of which is the value of the change of the second current value ($i'_2$) and the subtrahend of which is the value of the change of the first current value ($i'_1$),
a twelfth difference (D12), the minuend of which is the fifteenth product (P15) and the subtrahend of which is the sixteenth product (P16).

**11.** Arc fault detection unit according to Patent Claim 10, **characterized in that** the arc voltage ($U_{lb}$) is a quotient, the dividend of which has terms of the twelfth difference (D12) and the divisor of which has terms of the eleventh difference (D11).

**12.** Arc fault detection unit according to Patent Claims 1 to 6, 8 or 10, **characterized**

**in that** at least one of the following terms is formed for the calculation of the arc voltage ($U_{lb}$):
a thirteenth difference (D13), the minuend of which is formed from the product of the sign of the first current value ($sgn(i_1)$) and the value of the change of the second current value ($i'_2$) and the subtrahend of which is formed from the product of the sign of the second current value ($sgn(i_2)$) and the value of the change of the first current value ($i'_1$).

**13.** Arc fault detection unit according to Patent Claim 12, **characterized in that** the arc voltage ($U_{lb}$) is a quotient, the dividend of which has terms of the twelfth difference (D12) and the divisor of which has terms of the thirteenth difference (D13).

**14.** Arc fault detection unit according to Patent Claims 1 to 6, 8, 10 or 12, **characterized in that** at least one of the following terms is formed for the calculation of the arc voltage ($U_{lb}$):

a third difference (D3), the minuend of which is the first product (P1) and the subtrahend of which is the second product (P2),
a fourth difference (D4), the minuend of which is the third product (P3) and the subtrahend of which is the fourth product (P4),
a fifth difference (D5), the minuend of which is the fifth product (P5) and the subtrahend of which is the sixth product (P6),
a sixth difference (D6), the minuend of which is the seventh product (P7) and the subtrahend of which is the eighth product (P8) .

**15.** Arc fault detection unit according to Patent Claim 14, **characterized in that** at least one of the following terms is formed for the calculation of the arc voltage ($U_{lb}$):

a ninth product (P9), formed from the third difference (D3) and the fourth difference (D4),
a tenth product (P10), formed from the fifth difference (D5) and the sixth difference (D6),
an eleventh product (P11), formed from the first difference (D1) and the sixth difference (D6),
a twelfth product (P12), formed from the second difference (D2) and the fourth difference (D4).

**16.** Arc fault detection unit according to Patent Claim 15, **characterized in that** at least one of the following terms is formed for the calculation of the arc voltage ($U_{lb}$):

a seventh difference (D7), the minuend of which is the ninth product (P9) and the subtrahend of which is the tenth product (P10),

an eighth difference (D8), the minuend of which is the eleventh product (P11) and the subtrahend of which is the twelfth product (P12).

**17.** Arc fault detection unit according to Patent Claim 16, **characterized in that** the arc voltage ($U_{lb}$) is a quotient, the dividend of which has terms of the seventh difference (D7) and the divisor of which has terms of the eighth difference (D8) .

**18.** Arc fault detection unit according to Patent Claims 1 to 6, 8, 10, 12, 14, 15 or 16, **characterized in that** at least one of the following terms is formed for the calculation of the arc voltage ($U_{lb}$):

a fourteenth difference (D14), the minuend of which is the third current value ($i_3$) and the subtrahend of which is the first current value ($i_1$),
a seventeenth product (P17), formed from the ninth difference (D9) and the sixth difference (D6),
an eighteenth product (P18), formed from the fourteenth difference (D14) and the fourth difference (D4),
a fifteenth difference (D15), the minuend of which is the seventeenth product (P17) and the subtrahend of which is the eighteenth product (P18).

**19.** Arc fault detection unit according to Patent Claim 18, **characterized in that** the arc voltage ($U_{lb}$) is a quotient, the dividend of which has terms of the seventh difference (D7) and the divisor of which has terms of the fifteenth difference (D15) .

**20.** Arc fault detection unit according to one of the preceding patent claims, **characterized**

**in that** the first point in time is earlier than the second point in time or
**in that** the second point in time is earlier than the third point in time or
**in that** the first point in time is earlier than the second point in time and the latter is earlier than the third point in time.

**21.** Arc fault detection unit according to one of the preceding patent claims, **characterized in that** the evaluation unit is embodied in such a way that an arc fault detection signal (SLES) is output only if the current magnitude, in particular the current value, exceeds a second threshold value (SW2).

**22.** Circuit breaker, having an arc fault detection unit according to one of Patent Claims 1 to 21, which is connected to the circuit breaker and which are embodied in such a way that the electrical circuit is interrupted by the circuit breaker in response to an arc fault detection signal (SLES).

**23.** Short circuiter, having an arc fault detection unit according to one of Patent Claims 1 to 21, which is connected to the short circuiter and which are embodied in such a way that the electrical circuit is short-circuited by the short circuiter in response to an arc fault detection signal (SLES) in order to effect an extinguishing of the arc fault.

**24.** Method for arc fault detection for an electrical low-voltage circuit, wherein electrical voltage values and current magnitudes of the circuit are determined periodically, so that in each case

a first value pair of a voltage value ($u_1$) and of a current magnitude is present at a first point in time, and
a second value pair of a voltage value ($u_2$) and of a current magnitude is present at a second point in time,
that an arc voltage ($U_{lb}$) of an ignited arc, which is compared to a threshold value (SW), is calculated from the two value pairs and if said threshold value is exceeded, an arc fault detection signal (SLES) is output.

**Revendications**

**1.** Unité de détection d'un arc électrique parasite (SEE) destinée à un circuit de courant électrique basse tension, qui présente :

au moins un capteur de tension (SEU) qui est attribué au circuit électrique, à des fins de détermination périodique de tensions électriques ($u_m$) du circuit électrique ;

au moins un capteur de courant (SEI) qui est attribué au circuit électrique, à des fins de détermination périodique d'intensités de courant électrique du circuit électrique ;

qui sont tous deux reliés à une unité d'évaluation (AE) et qui sont conçus d'une manière telle que l'on détermine en continu des couples de valeurs d'une tension ($u_m$) et d'une intensité de courant à un certain moment tant et si bien que, respectivement, l'on se trouve en présence :

d'un premier couple de valeurs d'une tension ($u_1$) et d'une intensité de courant à un premier moment, et d'un deuxième couple de valeurs d'une tension ($u_2$) et d'une intensité de courant à un deuxième moment ; **caractérisée en ce que**, à partir des deux couples de valeurs, on calcule une tension d'arc électrique ($U_{lb}$) d'un arc électrique allumé, que l'on compare à une valeur seuil (SW) et, dans le cas d'un dépassement vers le haut de cette dernière en termes de quantité, on déclenche un signal de reconnaissance d'un arc électrique parasite (SLES).

**2.** Unité de détection d'un arc électrique parasite selon la revendication 1, **caractérisée**

**en ce que** l'on se trouve en présence d'un troisième couple de valeurs d'une tension ($u_3$) et d'une intensité de courant à un troisième moment ;

**en ce que**, à partir des trois couples de valeurs, on calcule une tension d'arc électrique ($U_{lb}$), que l'on compare à une valeur seuil (SW) et, dans le cas d'un dépassement de cette dernière vers le haut en termes de quantité, on déclenche un signal de reconnaissance d'un arc électrique parasite (SLES).

**3.** Unité de détection d'un arc électrique parasite selon la revendication 1 ou 2, **caractérisée**
**en ce que** l'on détermine, à titre d'intensité du courant électrique, une valeur de courant électrique ($i_m$) et/ou une valeur pour la modification du courant électrique après le temps ($i'_m$) .

**4.** Unité de détection d'un arc électrique parasite selon la revendication 3, **caractérisée**

**en ce que**, dans le cas de la détermination de la valeur de courant électrique ($i_m$), on détermine à partir de cette dernière une valeur pour la modification du courant électrique après le temps ($i'_m$) ou **en ce que**, dans le cas de la détermination de la valeur pour la modification du courant électrique après le temps ($i'_m$), on détermine, à partir de la valeur en question, la valeur du courant électrique ($i_m$) ; d'une manière telle que le couple de valeurs présente une tension ($u_m$), une valeur du courant ($i_m$) et une valeur pour la modification du courant électrique après le temps ($i'_m$).

**5.** Unité de détection d'un arc électrique parasite selon la revendication 1, 2, 3 ou 4, **caractérisée**
**en ce que** l'unité d'évaluation (AE) est conçue d'une manière telle que le calcul de la tension de l'arc électrique ($U_{lb}$) est mis en œuvre à l'aide d'une équation différentielle ou de la solution de cette dernière.

**6.** Unité de détection d'un arc électrique parasite selon la revendication 1, 2, 3, 4 ou 5, **caractérisée**
**en ce que**, pour le calcul de la tension de l'arc électrique ($U_{lb}$), on forme au moins un des termes indiqués ci-après :

un treizième produit (P13) que l'on obtient à partir de la deuxième valeur de courant ($i_2$) et de la première tension ($u_1$) ;

un quatorzième produit (P14) que l'on obtient à partir de la première valeur de courant ($i_1$) et de la deuxième tension ($u_2$) ;

une neuvième différence (D9), dont le diminuende représente la deuxième valeur de courant ($i_2$) et dont le diminuteur représente la première valeur de courant ($i_1$) ;

une dixième différence (D10), dont le diminuende représente le treizième produit (P13) et dont le diminuteur représente le quatorzième produit (P14).

**7.** Unité de détection d'un arc électrique parasite selon la revendication 6, **caractérisée**
**en ce que** la tension de l'arc électrique ($U_{lb}$) représente un quotient, dont le terme faisant office de dividende comprend la dixième différence (D10) et dont le terme faisant office de diviseur comprend la neuvième différence (D9).

**8.** Unité de détection d'un arc électrique parasite selon les revendications 1 à 6, **caractérisée**
**en ce que**, pour le calcul de la tension de l'arc électrique ($U_{lb}$), on forme au moins un des termes indiqués ci-après :

un premier produit (P1) que l'on obtient à partir de la troisième tension ($u_3$) et de la première valeur de courant ($i_1$) ;

un deuxième produit (P2) que l'on obtient à partir de la première tension ($u_1$) et de la troisième valeur de courant ($i_3$) ;

un troisième produit (P3) que l'on obtient à partir de la valeur de la modification de la deuxième valeur de courant après le temps ($i'_2$) et de la première valeur de courant ($i_1$) ;

un quatrième produit (P4) que l'on obtient à partir de la valeur de la modification de la première valeur de courant après le temps ($i'_1$) et de la deuxième valeur de courant ($i_2$) ;

un cinquième produit (P5) que l'on obtient à partir de la deuxième tension ($u_2$) et de la première valeur de courant ($i_1$) ;

un sixième produit (P6) que l'on obtient à partir de la première tension ($u_1$) et de la deuxième valeur de courant ($i_2$) ;

un septième produit (P7) que l'on obtient à partir de la valeur de la modification de la troisième valeur de courant après le temps ($i'_3$) et de la première valeur de courant ($i_1$) ;

un huitième produit (P8) que l'on obtient à partir de la valeur de la modification de la première valeur de courant après le temps ($i'_1$) et de la troisième valeur de courant ($i_3$) ;

une première différence (D1), dont on forme le diminuende à partir du produit du signe de la première valeur de courant ($sgn(i_1)$) et de la deuxième valeur de courant ($i_2$) et le diminuteur à partir du produit du signe de la deuxième valeur de courant ($sgn(i_2)$) et de la première valeur de courant ($i_1$) ;

une deuxième différence (D2), dont on forme le diminuende à partir du produit du signe de la première valeur de courant ($sgn(i_1)$) et de la troisième valeur de courant ($i_3$) et le diminuteur à partir du produit du signe de la troisième valeur de courant ($sgn(i_3)$) et de la première valeur de courant ($i_1$).

9.  Unité de détection d'un arc électrique parasite selon la revendication 8, **caractérisée en ce que** la tension de l'arc électrique ($U_{lb}$) représente un quotient, dont le terme faisant office de dividende comprend la dixième différence (D10) et dont le terme faisant office de diviseur comprend la première différence (D1).

10. Unité de détection d'un arc électrique parasite selon les revendications 1 à 6 ou 8, **caractérisée en ce que**, pour le calcul de la tension de l'arc électrique ($U_{lb}$), on forme au moins un des termes indiqués ci-après :

    un quinzième produit (P15) que l'on obtient à partir de la valeur de la modification de la deuxième valeur de courant ($i'_2$) et de la première tension ($u_1$) ;

    un seizième produit (P16) que l'on obtient à partir de la valeur de la modification de la première valeur de courant ($i'_1$) et de la deuxième tension ($u_2$) ;

    une onzième différence (D11), dont le diminuende représente la valeur de la modification de la deuxième valeur de courant ($i'_2$) et dont le diminuteur représente la valeur de la modification de la première valeur de courant ($i'_1$) ;

    une douzième différence (D12), dont le diminuende représente le quinzième produit (P15) et dont le diminuteur représente le seizième produit (P16).

11. Unité de détection d'un arc électrique parasite selon la revendication 10, **caractérisée en ce que** la tension de l'arc électrique ($U_{lb}$) représente un quotient, dont le terme faisant office de dividende comprend la douzième différence (D12) et dont le terme faisant office de diviseur comprend la onzième différence (D11).

12. Unité de détection d'un arc électrique parasite selon les revendications 1 à 6, 8 ou 10, **caractérisée en ce que**, pour le calcul de la tension de l'arc électrique ($U_{lb}$), on forme au moins un des termes indiqués ci-après : une treizième différence (D13), dont on forme le diminuende à partir du produit du signe de la première valeur de courant ($sgn(i_1)$) et de la valeur de la modification de la deuxième valeur de courant ($i'_2$) et le diminuteur à partir du produit du signe de la deuxième valeur de courant ($sgn(i_2)$) et de la valeur de la modification de la première valeur de courant ($i'_1$).

13. Unité de détection d'un arc électrique parasite selon la revendication 12, **caractérisée en ce que** la tension de l'arc électrique ($U_{lb}$) représente un quotient, dont le terme faisant office de dividende comprend la douzième différence (D12) et dont le terme faisant office de diviseur comprend la treizième différence (D13).

14. Unité de détection d'un arc électrique parasite selon la revendication 1 à 6, 8, 10 ou 12, **caractérisée en ce que**, pour le calcul de la tension de l'arc électrique ($U_{lb}$), on forme au moins un des termes indiqués ci-après :

    une troisième différence (D3), dont le diminuende représente le premier produit (P1) et dont le diminuteur représente le deuxième produit (P2) ;
une quatrième différence (D4), dont le diminuende représente le troisième produit (P3) et dont le diminuteur représente le quatrième produit (P4) ;
une cinquième différence (D5), dont le diminuende représente le cinquième produit (P5) et dont le diminuteur représente le sixième produit (P6) ;
une sixième différence (D6), dont le diminuende représente le septième produit (P7) et dont le diminuteur représente le huitième produit (P8).

15. Unité de détection d'un arc électrique parasite selon la revendication 14, **caractérisée en ce que**, pour le calcul de la tension de l'arc électrique ($U_{lb}$), on forme au moins un des termes indiqués ci-après :

un neuvième produit (P9) que l'on obtient partir de la troisième différence (D3) et de la quatrième différence (D4) ;
un dixième produit (P10) que l'on obtient à partir de la cinquième différence (D5) et de la sixième différence (D6) ;
un onzième produit (P11) que l'on obtient à partir de la première différence (D1) et de la sixième différence (D6) ;
un douzième produit (P12) que l'on obtient à partir de la deuxième différence (D2) et de la quatrième différence (D4).

16. Unité de détection d'un arc électrique parasite selon la revendication 15, **caractérisée en ce que**, pour le calcul de la tension de l'arc électrique ($U_{lb}$), on forme au moins un des termes indiqués ci-après :

une septième différence (D7), dont le diminuende représente le neuvième produit (P9) et dont le diminuteur représente le dixième produit (P10) ;
une huitième différence (D8), dont le diminuende représente le onzième produit (P11) et dont le diminuteur représente le douzième produit (P12).

17. Unité de détection d'un arc électrique parasite selon la revendication 16, **caractérisée en ce que** la tension de l'arc électrique ($U_{lb}$) représente un quotient, dont le terme faisant office de dividende comprend la septième différence (D7) et dont le terme faisant office de diviseur comprend la huitième différence (D8).

18. Unité de détection d'un arc électrique parasite selon la revendication 1 à 6, 8, 10, 12, 14, 15 ou 16, **caractérisée en ce que**, pour le calcul de la tension de l'arc électrique ($U_{lb}$), on forme au moins un des termes indiqués ci-après :

une quatorzième différence (D14), dont le diminuende représente la troisième valeur de courant ($i_3$) et dont le diminuteur représente la première valeur de courant ($i_1$) ;
un dix-septième produit (P17) que l'on obtient à partir de la neuvième différence (D9) et de la sixième différence (D6) ;
un dix-huitième produit (P18) que l'on obtient à partir de la quatorzième différence (D14) et de la quatrième différence (D4) ;
une quinzième différence (P15) dont le diminuende représente le dix-septième produit (P17) et dont le diminuteur représente le dix-huitième produit (P18).

19. Unité de détection d'un arc électrique parasite selon la revendication 18, **caractérisée en ce que** la tension de l'arc électrique ($U_{lb}$) représente un quotient, dont le terme faisant office de dividende comprend la septième différence (D7) et dont le terme faisant office de diviseur comprend la quinzième différence (D15).

20. Unité de détection d'un arc électrique parasite selon l'une quelconque des revendications précédentes, **caractérisée**

**en ce que**, le premier moment est situé dans le temps avant le deuxième moment ; ou
**en ce que** le deuxième moment est situé dans le temps avant le troisième moment ; ou
**en ce que** le premier moment est situé dans le temps avant le deuxième moment et celui-ci est situé dans le temps avant le troisième moment.

21. Unité de détection d'un arc électrique parasite selon l'une quelconque des revendications précédentes, **caractérisée en ce que** l'unité d'évaluation est conçue d'une manière telle que l'on déclenche un signal de reconnaissance d'un arc électrique parasite (SLES) uniquement lorsque l'intensité du courant, en particulier la valeur du courant, dépasse vers le haut une deuxième valeur seuil (SW2).

**22.** Disjoncteur, qui présente une unité de reconnaissance d'un arc électrique parasite selon l'une quelconque des revendications 1 à 21, qui est reliée au disjoncteur, et qui sont conçus d'une manière telle que, en présence d'un signal de reconnaissance d'un arc électrique parasite (SLES), le circuit électrique est interrompu par l'intermédiaire du disjoncteur.

**23.** Court-circuiteur, qui présente une unité de reconnaissance d'un arc électrique parasite selon l'une quelconque des revendications 1 à 21, qui est reliée au court-circuiteur, et qui sont conçus d'une manière telle que, en présence d'un signal de reconnaissance d'un arc électrique parasite (SLES), le circuit électrique est mis en court-circuit par l'intermédiaire du court-circuiteur afin d'obtenir une extinction de l'arc électrique parasite.

**24.** Procédé destiné à la reconnaissance d'un arc électrique parasite pour un circuit de courant électrique basse tension, dans lequel on détermine d'une manière périodique des tensions électriques et des intensités de courant du circuit électrique, d'une manière telle que l'on se trouve respectivement en présence :

d'un premier couple de valeurs d'une tension ($u_1$) et d'une intensité de courant à un premier moment, et d'un deuxième couple de valeurs d'une tension ($u_2$) et d'une intensité de courant à un deuxième moment ; tant et si bien que, à partir des deux couples de valeurs, on calcule une tension d'arc électrique ($U_{1b}$) d'un arc électrique allumé, que l'on compare à une valeur seuil (SW) et, dans le cas d'un dépassement de cette dernière vers le haut en termes de quantité, on déclenche un signal de reconnaissance d'un arc électrique parasite (SLES).

FIG 2

FIG 3

FIG 4

## FIG 5

## FIG 6

**FIG 7**

NSE — ELT1 — ESCH — SS — SI — SI — ALT1 — ALT2 — ABG. I — ABG. II — ARB — SEI1 — SEU1 — SEE — KS

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2916455 A1
- EP 2424059 A2
- US 7627400 B2
- DE 102004056436 A1